Europäisches Patentamt

(19) European Patent Office    (11) Numéro de publication: **0 000 857**
**B1**

Office européen des brevets

(12)      **FASCICULE DE BREVET EUROPEEN**

(45) Date de publication du fascicule de brevet:    (51) Int. Cl.³: **H 03 K 17/78,** H 01 L 31/16,
29.04.81      **H 03 K 17/18**

(21) Numéro de dépôt: **78810008.9**

(22) Date de dépôt: **07.07.78**

(54) Dispositif de commande photoélectrique.

(30) Priorité: **08.07.77 GB 2881477**

(43) Date de publication de la demande:
**21.02.79 Bulletin 79/4**

(45) Mention de la délivrance du brevet:
**29.04.81 Bulletin 81/17**

(84) Etats contractants désignés:
**BE CH DE FR GB LU NL SE**

(56) Documents cités:
**DE-A-2 516 171**
**DE-A-2 517 030**
**FR-A-2 277 467**
**GB-A-1 418 318**
**IBM TECHNICAL DISCLOSURE BULLETIN**
**vol. 18, n° 2, juillet 1975**
**New York**
**Uberbacher: »Fiber optic illuminated switch«,**
**page 483**

(73) Titulaire: **BATTELLE MEMORIAL INSTITUTE, 7 route de Drize, CH-1227 Carouge/Genève (CH)**

(72) Inventeur: **Harmer, Alan Lewis, route de Pré-Marais 29, CH-1233 Bernex (CH)**

(74) Mandataire: **Dousse, Blasco et al, 7, route de Drize, CH-1227 Carouge/Genève (CH)**

# Dispositif de commande photoélectrique

Il existe de nombreuses applications dans lesquels les interrupteurs ou commutateurs électro-mécaniques ou électroniques (du type capacitif ou résistif) n'offrent pas une sécurité suffisante ou une bonne fiabilité de fonctionnement. C'est notamment le cas d'appareils travaillant avec des circuits haute tension, comme les circuits associés aux tubes cathodiques des appareils de télévision.

Il est comme de remédier à ces inconvénients en utilisant des systèmes électro-optiques dans lesquels la lumière émise par une source de lumière est dirigée sélectivement sur un photo-détecteur servant à commander un interrupteur, suivant qu'il reçoit ou non une certaine quantité de lumière. Accessoirement on a également proposé d'utiliser la lumière de cette même source en tant que témoin lumineux ou moyen d'affichage. Les solutions proposées en vue d'utiliser la lumière de la source pour actionner un photo-détecteur ou pour éclairer les moyens d'affichage, ont recours à une surface semi-réfléchissante pour dévier une portion de la lumière dirigée contre la surface d'affichage vers le photo-détecteur. L'inconvénient de ces solutions réside essentiellement dans le fait qu'une portion importante de la lumière émise par la source est perdue aussi bien pour l'affichage que pour actionner le photo-détecteur. Etant donné que la lumière de la source est généralement de faible intensité, provenant d'une photo-diode et transmise par une fibre optique, il est important, pour la qualité de l'affichage et pour la fiabilité de fonctionnement du photo-détecteur, de réduire ces pertes à un minimum.

On a certes déjà proposé dans le DE-OS 2 516 171 d'utiliser une surface réfléchissante solidaire d'un organe de commande mobile entre deux positions pour diriger la lumière émise par une source lumineuse vers un photo-détecteur dans l'une des deux positions de l'organe de commande. Toutefois, cette solution ne permet pas d'éclairer un moyen d'affichage dans l'autre position de l'organe de commande. L'utilisation de la source lumineuse destinée à actionner le photo-détecteur pour l'éclairage de l'affichage est par ailleurs décrite dans le brevet GB 1 418 318. Toutefois, dans cette solution sans organe mobile, la surface réfléchissante utilisée pour diriger la lumière de la source vers le photo-détecteur est celle du doigt de l'utilisateur placé en face de la lumière sortant d'une fibre optique conduisant la lumière émise par la source lumineuse. Il est évident que la lumière réfléchie par un doigt ne saurait être comparable à celle réfléchie par un miroir. Le contraste d'un tel dispositif est donc faible et la marge de sécurité entre l'état éclairé et non éclairé est extrêmement réduite.

Le but de la présente invention est de remédier au moins partiellement aux inconvénients susmentionnés.

A cet effet, la présente invention a pour objet un dispositif de commande photo-électrique, comprenant une source de lumière, un photo-détecteur, un interrupteur électrique actionné par le photo-détecteur en fonction de l'intensité lumineuse reçue et un organe de commande solidaire d'un élément réflecteur et susceptible d'être amené dans deux positions limites, dans l'une desquelles la lumière de ladite source est dirigée vers le photo-détecteur, caractérisé par le fait que ce dispositif comporte des moyens d'affichage disposés pour recevoir la lumière de ladite source lorsque ledit organe de commande occupe l'autre desdites positions limites.

Les dessins annexés illustrent, schématiquement et à titre d'exemple, quelques formes d'exécution du dispositif objet de la présente invention.

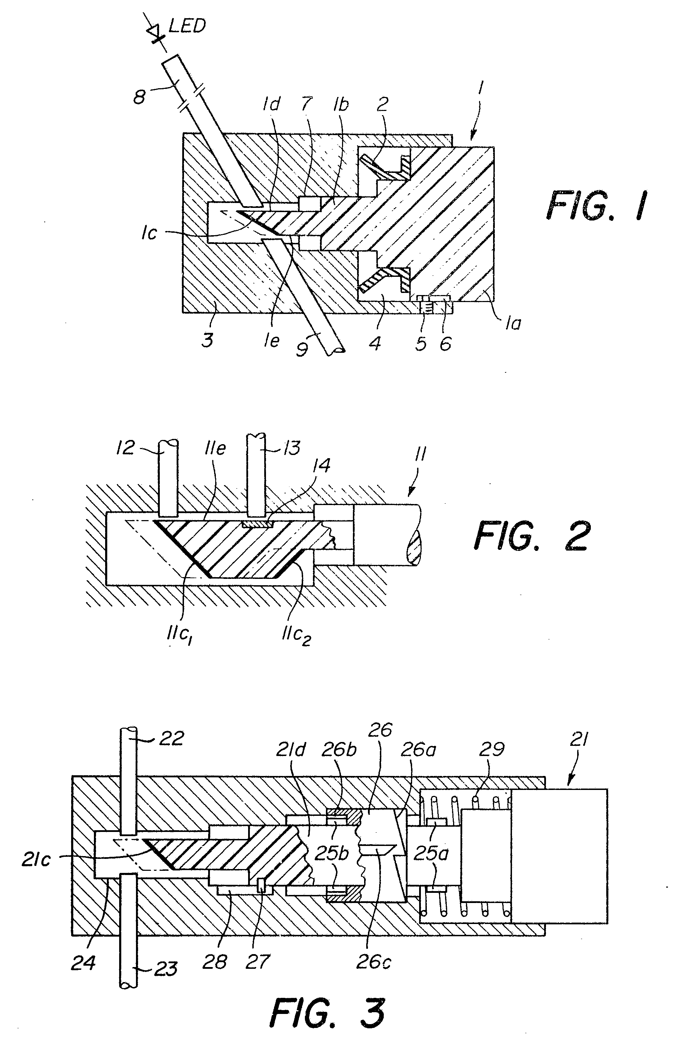

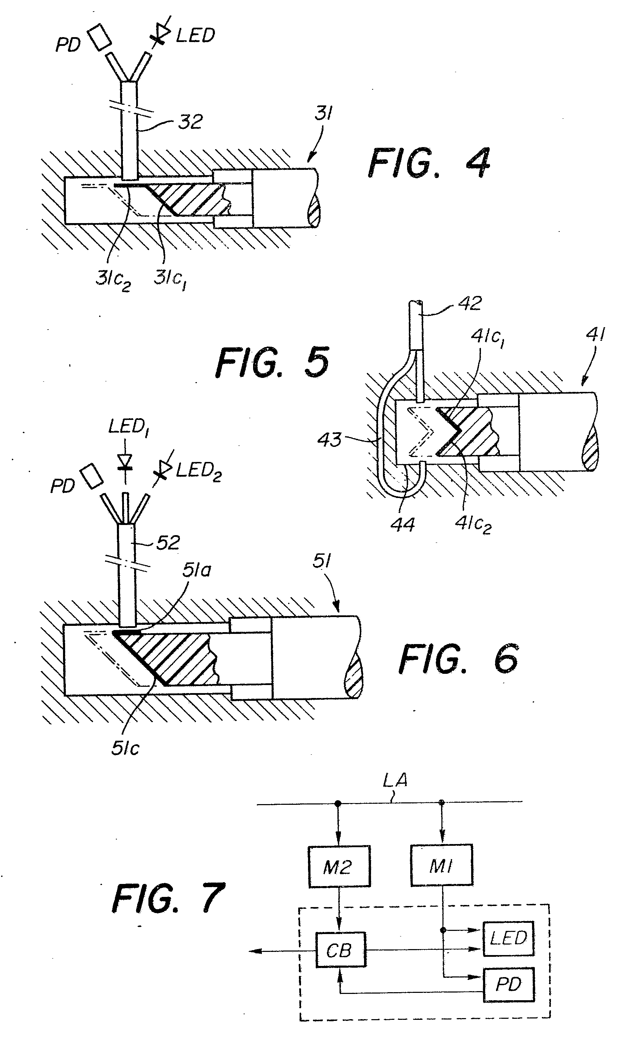

Les figures 1 et 2 représentent deux formes d'exécution de dispositifs de commande mono-stables; les figures 3 à 5 représentent trois autres formes d'exécution de dispositifs de commande bistables; la figure 6 illustre une variante du dispositif de commande bistable avec deux sources lumineuses; la figure 7 est un schéma-bloc du circuit électronique associé aux dispositifs de commandes des figures 1 à 6.

Dans le cas des deux formes d'exécution des figures 1 et 2 se rapportant à un dispositif de commande monostable, le poussoir de commande est représenté en position de repos, c'est-à-dire dans la position dans laquelle la lumière de la source est utilisée pour l'affichage.

La figure 1 représente une forme d'exécution dans laquelle l'organe de commande est constitué par un bouton poussoir 1 transparent à une position stable, constamment rappelé dans cette position par un organe de rappel élastique 2. Ce bouton poussoir 1 est monté coulissant dans un bloc d'aluminium 3 présentant un logement 4 destiné à recevoir la tête 1a du bouton poussoir 1 retenue à l'encontre de la pression de l'organe de rappel 2 par une vis de butée 5 engagée dans un dégagement 6 de la tête 1a. Ce bouton 1 comporte encore une partie de guidage 1b engagée dans un alésage 7 ménagé dans le fond du logement 4. Le bouton poussoir se termine par un prisme dont la face d'extrémité 1c est de préférence métallisée et constitue un élément réflecteur.

Une fibre optique 8 reliée à une source de lumière constituée par une diode électroluminescente LED est logée dans le bloc d'aluminium 3 et débouche à proximité du prisme 1c. Cette fibre optique 8 est disposée par rapport à la face réfléchissante du prisme, de manière que la lumière qu'elle envoie contre cette face réfléchissante soit renvoyée contre la face externe du bouton poussoir, réalisant ainsi l'affichage.

Une seconde fibre optique 9 est disposée dans le bloc 3, du côté de la face métallisée du prisme 1c. Elle s'étend dans le prolongement de la fibre 8 et conduit à un photo-détecteur (non représenté). La face réfléchissante du prisme 1c est adjacente à deux faces transparentes parallèles 1d et 1e, de sorte que lorsque le bouton poussoir est pressé au fond de son logement 4, ces deux faces parallèles transparentes se trouvent respectivement vis-à-vis des extrémités des fibres optiques 8 et 9. Par conséquent, les rayons lumineux sortant de la fibre 8 et provenant de la source LED traversent les faces 1d et 1e et pénètrent dans la fibre 9 qui les conduits jusqu'au photo-détecteur. Dès que la pression sur le bouton poussoir 1 est relachée, il est ramené en arrière par l'organe de rappel 2 et la lumière issue de la fibre 8 rencontre 1a face réfléchissante 1c du prisme qui la renvoie contre la face externe de la tête 1a du bouton poussoir. Dans ce cas l'affichage ne constitue pas une indication de l'état de l'interrupteur ou du commutateur commandé par le dispositif décrit, mais plutôt un simple moyen d'éclairage du bouton.

La forme d'exécution de la figure 2 ne diffère que légèrement de celle de la figure 1. Le bouton poussoir 11 de cette forme d'exécution comporte deux faces réfléchissantes $11c_1$ et $11c_2$ disposées à 90° l'une de l'autre et à 45° par rapport à l'axe longitudinal du bouton poussoir 11. Deux fibres 12 et 13 parallèles l'une à l'autre et perpendiculaires à l'axe longitudinal du poussoir 11 aboutissent à proximité de la face longitudinale 11e du poussoir opposée aux faces réfléchissantes $11c_1$ et $11c_2$, la fibre 12 se trouvant vis-à-vis de la face $11c_1$ et la fibre 13, vis-à-vis de la face $11c_2$. L'autre extrémité de la fibre 12 est reliée à la source lumineuse constituée par la photo-diode LED, tandis que la fibre 13 aboutit au photo-détecteur. Un écran opaque 14 est ménagé le long de la face longitudinale 11e du poussoir. Cet écran 14 est placé de manière à se trouver devant l'extrémité de la fibre 13 en position de repos du bouton poussoir 11.

La face réfléchissante $11c_1$ s'étend sur toute la largeur du poussoir 11, tandis que la face $11c_2$ ne s'étend que sur la moitié environ de cette largeur. En position de repos du bouton poussoir, la fibre optique 12 se trouve vis-à-vis de la portion de la face réfléchissante $11c_1$ adjacente à l'extrémité du bouton poussoir 11. Les rayons lumineux sortant de la fibre 12 et réfléchis par la face $11c_1$ selon une direction parallèle à l'axe longitudinal du poussoir 11 sortent par la face externe nou indiquér de la tête de ce bouton. Lorsque le bouton poussoir est poussé, l'écran 14 s'écarte de la fibre 13, la face réfléchissante $11c_1$ se déplace également, de sorte que la lumière qu'elle reçoit est renvoyée contre la face réfléchissante $11c_2$ aui la dirige vers la fibre 13 pour actionner le photo-détecteur.

La forme d'exécution illustrée par la figure 3 se rapporte à un dispositif de commande, dans lequel le bouton poussoir 21 est susceptible d'occuper alternativement deux positions stables. Le mécanisme permettant de placer le bouton poussoir 21 dans ces deux positions est bien connu. Il est représenté ici schématiquement et à titre d'exemple, étant entendu qu'il peut être remplacé par n'importe quel autre mécanisme du même genre. Ce mécanisme comporte deux paires d'ergots 25a, 25b solidaires d'une tige cylindrique 21d du bouton poussoir 21 et une double came 26 montée rotativement autour de la tige 21d. Cette came 26 comporte deux dentures à rochet 26a, 26b de quatre dents chacune décalées angulairement. En outre, la denture 26b comporte deux rainures axiales 26c diamétralement opposées destinées à définir une des deux positions axiales du bouton poussoir 21. Une saillie 27 solidaire de la tige 21d et engagée dans une rainure 28 empêche tout déplacement angulaire du bouton poussoir 21. Lors de chaque pression sur le bouton poussoir 21, les ergots 25a viennent en prise avec la denture 26a et font tourner la came 26 d'un angle suffisant pour que, en relachant le bouton poussoir, soumis alors à l'action d'un ressort de rappel 29, les ergots 25b rencontrent la dent suivante de la came 26b et continuent a faire tourner la came de 90°. Une fois sur deux les ergots 25b viennent en prise avec les dents qui se terminent par une des rainures axiales 26c. En y pénétrant, ils placent le bouton poussoir dans sa position axiale haute tandis que les dents suivantes de la came 26b, ne présentant pas de rainures 26c définiront, lors de la pression suivante sur le bouton poussoir, la position axiale basse de ce bouton.

L'extrémité interne de ce bouton poussoir présente une face réfléchissante 21c inclinée à 45° par rapport à l'axe longitudinal du bouton poussoir et dont la face externe est de préférence métallisée. Comme dans la forme d'exécution de la figure 1, deux fibres optiques 22 et 23 débouchent vis-à-vis l'une de l'autre dans un logement 24 recevant l'extrémité interne du bouton poussoir 21. Contrairement à cette forme d'exécution, la transmission de lumière de la fibre 22 alimentée par la source à la fibre 23 aboutissant au photo-détecteur ne se fait pas à travers deux faces parallèles adjacentes à la face réfléchissante 21c, mais directement à travers le logement 24, l'extrémité du bouton poussoir étant écartée de la trajectoire joignant ces deux fibres 22 et 23. Dans la seconde position stable du poussoir, représentée en traits mixtes, la face réfléchissante 21c est interposée dans la trajectoire reliant les fibres 22 et 23, dirigeant la lumière sortant de la fibre 22 contre la face externe du bouton 21 afin de l'éclairer.

Dans cette forme d'exécution, la face externe du bouton 21 n'est éclairée que dans l'une des deux positions stables de ce bouton indiquant ainsi l'état »marche« ou »arrêt« ou »enclenché« »déclenché« de l'interrupteur. Un des avantages de cette forme d'exécution vient du fait qu'en position d'excitation du photo-détecteur PD, la face réfléchissante métallisée 21c est disposée entre les fibres optiques 22, 23 et l'extérieur, empêchant par conséquent la lumière ambiante d'interférer avec celle provenant de la diode photo-électrique. Cette même face réfléchissante 21c empêche également toute lumière d'atteindre le photo-détecteur dans l'autre position du bouton poussoir, en venant se placer devant l'extrémité de la fibre 23 débouchant dans le logement 24.

Comme on l'a déjà mentionné, le dispositif de commande selon l'invention permet de séparer la commande elle-même de l'interrupteur ou du commutateur, garantissant par la même occasion une isolation totale entre la commande actionnée manuellement et l'interrupteur électrique proprement dit. Bien entendu, et compte tenu de l'utilisation d'un élément de transmission à fibre optique reliant la partie »commande« à la partie »interrupteur«, un tel dispositif est également approprié à la commande à distance. Dans le cas de la commande à distance, on est toutefois tenu d'utiliser des fibres optiques à très faibles pertes afin de conserver une intensité lumineuse suffisante pour l'excitation du photo-détecteur. Ces fibres sont relativement chères; par conséquent il est intéressant dans ce cas d'envisager une solution dans laquelle une même fibre conduit la lumière de la source lumineuse au bouton poussoir de commande et ramène cette lumière vers le photo-détecteur suivant la position du bouton poussoir.

Une telle forme d'exécution est illustrée par la figure 4, dans laquelle le bouton poussoir 31 comporte une première surface réfléchissante $31c_1$ diposée à 45° par rapport à l'axe de la fibre 32 et à 45° par rapport à la surface externe du bouton poussoir servant à l'affichage comme dans le cas des autres formes d'exécution décrites. Une seconde surface réfléchissante $31c_2$, perpendiculaire à l'axe de la fibre optique 32 est disposée dans le prolongement de l'extrémité intérieure du bouton poussoir 31. Ce bouton poussoir est à deux positions stables comme celui de la forme d'exécution précédente. Ainsi, les surfaces réfléchissantes $31c_1$, $31c_2$ sont placées alternativement en face de l'extrémité de la fibre 32, de sorte que la lumière provenant de la diode photoélectrique est tantôt dirigée contre la face externe du bouton poussoir 31, tantôt renvoyée dans la fibre 32. L'autre extrémité de cette fibre comporte une connexion en Y pour séparer la lumière émise par la diode LED de celle transmise au photo-détecteur PD.

La figure 5 illustre une autre forme d'exécution permettant de transmettre la lumière dans deux directions à l'aide d'une seule fibre. De nouveau on a recours à un bouton poussoir 41 bistable du type de celui décrit en relation avec la figure 3. L'extrémité du bouton poussoir comporte une double surface réfléchissante $41c_1$, $41c_2$ formant chacune un angle de 45° avec l'axe du bouton poussoir et un angle de 90° entre elles. La fibre optique commune 42 se termine par une boucle 43 interrompue par le logement 44 du bouton poussoir 41. Les deux branches de cette boucle 43 coupées par le logement 44 se trouvent, en position pressée du bouton poussoir 41, vis-à-vis des surfaces réfléchissantes $41c_1$, $41c_2$ qui dirigent la lumière vers la face externe du bouton poussoir. Dans l'autre position de ce bouton, dessinée en trait continu, la lumière de la source passe d'un côté à l'autre du logement 44 et revient par la fibre optique 42 comme dans la forme d'exécution précédente.

Enfin la forme d'exécution de la figure 6 illustre une variante dans laquelle deux sources $LED_1$ et $LED_2$ alimentent une fibre optique commune 52. Le bouton poussoir 51 porte un miroir sélectivement réfléchissant 51a destiné à s'interposer entre l'extrémité de sortie de la fibre 52 et la face réfléchissante 51c du bouton poussoir dans l'une des deux positions stables du bouton 51. Les deux sources émettent de la lumière de longueur d'onde spécifique. Par exemple, la source $LED_1$ peut émettre dans l'infra-rouge et le miroir 51a ne réfléchir que cette longueur d'onde. L'autre source $LED_2$ émet alors de la lumière visible qui n'est pas réfléchie par le miroir. On peut aussi envisager un affichage bi-color le miroir 51a filtrant une des deux longueurs d'ondes émises par les diodes $LED_1$ et $LED_2$ dans une position axiale du bouton 51 affichant ainsi une couleur et réfléchissant l'autre vers le photo-détecteur, tandis que dans l'autre position axiale du bouton 51, les deux longueurs d'ondes sont envoyées contre la face externe du bouton et l'affichage change de couleur.

La figure 7 illustre, sous la forme d'un schéma-bloc, un circuit électronique prévu pour être associé aux dispositifs de commande décrits précédemment, notamment aux dispositifs bistables.

Ce circuit comporte une ligne d'alimentation LA sur laquelle sont branchés deux multivibrateurs M1 et M2. Le multivibrateur M1 est connecté à la source de lumière constituée par la photo-diode LED et au photo-détecteur PD tous deux reliés au dispositif de commande par une fibre optique ou par une fibre optique commune.

Le multivibrateur M1, émet des impulsions très courtes avec une fréquence de répétition relativement basse, choisies pour que la lumière émise par la diode LED ne soit pratiquement pas visible à l'œil, mais soit détectable par le photo-détecteur PD. Ce photo-détecteur est relié à l'entrée d'un commutateur bistable CB dont une autre entrée est reliée au multivibrateur M2. Les deux sorties de ce commutateur sont reliées à la diode LED et au canal de sélection, dans le cas d'un appareil de télévision par exemple.

Lorsque le bouton poussoir est actionné, un changement de niveau de signal est enregistré par le photo-détecteur PD qui actionne le commutateur bistable CB. Celui-ci connecte alors le multivibrateur M2 à la diode LED qui émet un signal d'alimentation qui rend la lumière de la diode visible à l'œil. Simultanément, le commutateur bistable CB envoir un signal de commande au canal de sélection.

## Revendications

1. Dispositif de commande photo-électrique, comprenant une source de lumière, un photo-détecteur, un interrupteur électrique actionné par le photo-détecteur en fonction de l'intensité lumineuse reçue et un organe de commande solidaire d'un élément réflecteur et susceptible d'être amené dans deux positions limites, dans l'une desquelles la lumière de ladite source est dirigée vers le photo-détecteur, caractérisé par le fait que ce dispositif comporte des moyens d'affichage disposés pour recevoir la lumière de ladite source lorsque ledit organe de commande occupe l'autre desdites positions limites.

2. Dispositif selon la revendication 1, caractérisé par le fait que ledit organe de commande est constitué par un bouton poussoir en matériau transparent, solidaire d'un prisme dont une face réfléchissante est orientée pour diriger la lumière de ladite source contre une face d'affichage externe, ce bouton étant monté coulissant pour déplacer ce prisme parallèlement à lui-même entre lesdites positions limites, l'une dans laquelle la face réfléchissante du prisme est placée à travers la trajectoire des rayons lumineux émis par ladite source, entre cette source et ledit photo-détecteur et l'autre où cette face réfléchissante est écartée de cette trajectoire.

3. Dispositif selon la revendication 2, caractérisé par le fait que la face réfléchissante du prisme est métallisée.

4. Dispositif selon la revendication 1, caractérisé par le fait que ledit organe de commande est associé à deux surfaces réfléchissantes, susceptibles d'être disposées sélectivement en face d'une extrémité d'une fibre optique, dont l'autre extrémité est reliée à ladite source de lumière et audit photo-détecteur, dans les deux positions limites respectives dudit organe, l'une desdites surfaces réfléchissantes étant constituée par une des faces d'un prisme et orientée pour diriger la lumière de ladite source émergeant de ladite fibre contre une surface d'affichage, l'autre de ces surfaces étant perpendiculaire à l'axe longitudinal de la portion de ladite fibre adjacente à son extrémité par laquelle sort la lumière provenant de ladite source pour renvoyer dans cette fibre au moins une partie de cette lumière.

5. Dispositif selon la revendication 1, caractérisé par le fait que la source de lumière comporte deux diodes électro-luminescentes émettant des radiations de longueurs d'ondes distinctes, à travers une fibre optique aboutissant à proximité dudit organe de commande, cet organe de commande comportant un prisme pour diriger sélectivement la lumière sortant de cette fibre vers une surface d'affichage, la face incidente dudit prisme présentant un miroir sélectivement réfléchissant de l'une desdites longueurs d'ondes, disposé de manière à s'interposer entre la fibre et la face réfléchissante du prisme dans l'une desdites positions dudit organe de commande et à s'écarter de la trajectoire entre cette face réfléchissante et la fibre dans l'autre position dudit organe de manière à renvoyer sélectivement l'une desdites radiations dans la fibre dont l'autre extrémité est reliée audit photo-détecteur.

6. Dispositif selon la revendication 1, caractérisé par le fait que ledit organe présente un écran opaque destiné à être interposé entre ladite source et ledit photo-détecteur dans la position limite dans laquelle ladite surface réfléchissante dirige la lumière vers lesdits moyens d'affichage.

## Patentansprüche

1. Photoelektrische Steuervorrichtung mit einer Lichtquelle, einem Photodetektor, einem von dem Photodetektor als Funktion der erhaltenen Lichtintensität betätigten elektrischen Unterbrecher und einem formschlüssig mit einem Reflektorelement verbundenen Steuerorgan, das in zwei Grenzstellungen gebracht werden kann, in deren einer das Licht der Quelle gegen den Photodetektor gerichtet ist, dadurch gekennzeichnet, daß diese Vorrichtung Anzeigemittel aufweist, die das Licht der Quelle empfangen können, wenn das Steuerorgan die andere der Grenzstellungen einnimmt.

2. Vorrichtung nach Anspruch 1, dadurch gekennzeichnet, daß das Steuerorgan aus einem Druckknopf aus durchsichtigem Material besteht, der formschlüssig mit einem Prisma verbunden ist, dessen eine reflektierende Seite so ausgerichtet ist, daß sie das Licht der Quelle gegen eine äußere Anzeigefläche wirft, wobei dieser Knopf gleitend angebracht ist, um dieses Prisma parallel zu sich selbst zwischen den Grenzstellungen zu verschieben, der einen, in der die reflektierende Fläche des Prismas zwischen dieser Quelle und dem Photodetektor quer zur Bahn der durch die Quelle ausgesandten Lichtstrahlen angeordnet ist, und der anderen, in der diese reflektierende Fläche von dieser Bahn entfernt liegt.

3. Vorrichtung nach Anspruch 2, dadurch gekennzeichnet, daß die reflektierende Fläche des Prismas metallisiert ist.

4. Vorrichtung nach Anspruch 1, dadurch gekennzeichnet, daß das Steuerorgan zwei reflektierende Flächen aufweist, die in den beiden entsprechenden Grenzstellungen des Organs wahlweise gegenüber einem Ende einer Lichtleitfaser liegen können, deren anderes Ende mit der Lichtquelle und dem Photodetektor verbunden ist, wobei die eine der reflektierenden Oberflächen aus einer der Prismenflächen besteht und so ausgerichtet ist, daß sie das aus der Faser austretende Licht der Quelle gegen eine Anzeigefläche richtet, und die andere dieser Oberflächen senkrecht zur Längsachse des Abschnitts der Faser nahe ihrem Ende verläuft, aus dem das aus der Quelle kommende Licht austritt, um wenigstens einen Teil dieses Lichts in diese Faser zurückzuleiten.

5. Vorrichtung nach Anspruch 1, dadurch gekennzeichnet, daß die Lichtquelle zwei elektrolumineszierende Dioden aufweist, die Strahlungen von bestimmten Wellenlängen quer durch eine Lichtleitfaser hindurch aussenden, die dicht an dem Steuerorgan endet, wobei dieses Steuerorgan ein Prisma aufweist, um wahlweise das aus dieser Faser austretende Licht auf eine Anzeigefläche zu richten, wobei die einfallende Fläche des Prismas einen wahlweise die eine dieser Wellenlängen reflektierenden Spiegel darstellt, der so angeordnet ist, daß er sich zwischen der Faser und der reflektierenden Fläche des Prismas in der einen der Stellungen des Steuerorgans einfügt und sich von der Bahn zwischen dieser reflektierenden Fläche und der Faser in die andere Stellung des Organs entfernt, so daß wahlweise eine der Strahlungen in die Faser zurückgeleitet wird, deren anderes Ende mit dem Photodetektor verbunden ist.

6. Vorrichtung nach Anspruch 1, dadurch gekennzeichnet, daß das Organ einen undurchsichtigen Schirm aufweist, der zwischen der Quelle und dem Photodetektor in der Grenzstellung eingesetzt werden soll, in der die reflektierende Oberfläche das Licht auf die Anzeigemittel richtet.

**Claims**

1. A photoelectric control device, comprising a light source, a photodetector, an electrical switch actuated by the photodetector as a function of the light intensity received and a control element rigid with a reflecting element which control element may occupy two end positions, in one of which positions the light from the said source is directed towards the photodetector, characterised in that the device comprises display means disposed in such a way as to receive the light from the said source when the said control element is in the other of the end positions.

2. A device as claimed in claim 1, characterised in that the control element is constituted by a push button of transparent material which is rigid with a prism having a reflecting surface orientated in such a way as to direct the light from the said source onto one external display surface, this button being slidably mounted in order to displace the prism parallel to itself between the said end positions, in one of which positions the reflecting surface of the prism is disposed across the path of the light beams emitted by the said source, between this source and the photodetector, and in the other of these positions the reflecting surface is removed from this path.

3. A device as claimed in claim 2, characterised in that the reflecting surface of the prism is metallised.

4. A device as claimed in claim 1, characterised in that the said control element is associated with two reflecting surfaces which may be selectively disposed opposite one end of an optical fibre whose other end is connected to the said light source and to the said photodetector, in the two respective end positions of the said element, one of the reflecting surfaces being constituted by one of the surfaces of a prism and being orientated in such a way as to direct the light from the said source which emerges from the said fibre onto a display surface, the other of these surfaces being perpendicular to the longitudinal axis of the portion of the said fibre adjacent to the end of the fibre through which the light from the said source is discharged, in order to return at least a portion of this light into the fibre.

5. A device as claimed in claim 1, characterised in that the light source comprises two electroluminescent diodes which emit radiation of different wavelengths through an optical fibre terminating in the vicinity of the said control element, this control element comprising a prism for selectively directing the light emerging from this fibre towards a display surface, the incident surface of the said prism having a mirror which selectively reflects one of the said wavelengths, which mirror is disposed in such a way as to be interposed between the fibre and the reflecting surface of the prism in one of the said positions of the control element and to be removed from the path between this reflecting surface and the fibre in the other position of the element in such a way as to return one of the said types of radiation into the firbre whose other end is connected to the said photodetector.

6. A device as claimed in claim 1, characterised in that the said element has an opaque screen designed to be interposed between the said source and the said photodetector in the end position in which the said reflecting surface directs the light towards the said display means.

FIG. I

FIG. 2

FIG. 3

0 000 857

FIG. 4

FIG. 5

FIG. 6

FIG. 7